# EUROPÄISCHE PATENTSCHRIFT

(11) **EP 0 477 424 B1**
(45) Veröffentlichungstag und Bekanntmachung des Hinweises auf die Patenterteilung: **22.02.1995**
(21) Anmeldenummer: 90118718.7
(22) Anmeldetag: 28.09.1990
(51) Int. Cl.: H01L 21/306, H01L 31/0236

(54) **Nasschemische Strukturätzung von Silizium**
Wet chemical etching to produce structured surfaces of silicon
Attaque chimique par voie humide pour structurer la surface de silicium

(43) Veröffentlichungstag der Anmeldung: 01.04.1992
(73) Patentinhaber: Siemens Solar GmbH, 51427 Bergisch Gladbach (DE)
(72) Erfinder: Holdermann, Konstantin, Dipl.-Chem.-Ing., D-8875 Offingen (DE)
(74) Vertreter: Fuchs, Franz-Josef, Dr.-Ing.

(56) Entgegenhaltungen:
- GB-A- 2 207 890
- US-A- 4 137 123
- IBM TECHNICAL DISCLOSURE BULLETIN, Band 19, Nr. 10, März 1977, Seite 3953, New York, US; E.F. BARAN et al.: "Anisotropic etching solution with high etch rate on single crystal silicon"

## Beschreibung

Die Erfindung betrifft ein Verfahren zur naßchemischen Texturätzung von Silizium.

Ein Verfahren zur Texturätzung ist aus US-PS 4 137 123 bekannt.

Die dort verwendete Ätzlösung enthält neben einem basischen Reagens noch einen Alkohol wie beispielsweise Ethylenglykol und außerdem 0,5 bis 10 Gewichtsprozent Silizium.

Aus der GB-A-2207890 ist ein Verfahren zur Strukturierung einer Siliziumoberfläche mit Hilfe eines Photolacks und einer Ätzlösung bekannt, bei dem zur Erzielung eines gleichmäßigen Ätzergebnisses die aus Kaliumhydroxid, Isopropanol und Wasser bestehende Ätzlösung durch Einblasen eines Gases verwirbelt wird.

Aus IBM TDB Vol. 19, No. 10, 1977, Seite 3953 ist es bekannt, eine aus Pyrocatechol, Ethylendiamin und Wasser bestehende Ätzlösung für kristallines Silizium mit Hilfe von Sauerstoff oder Wasserstoffperoxid zu oxidieren, um die Ätzrate zu erhöhen.

Eine texturierte Oberfläche reduziert breitbandig die Reflexion des einfallenden Lichtes und erhöht damit die absorbierte Lichtintensität. Dies führt letztlich zu einer Steigerung der Leistung einer Silizium-Solarzelle. Für die Herstellung kristalliner Silizium-Solarzellen stellt ein Verfahren zur naßchemischen Strukturätzung von Silizium eine wirtschaftliche Alternative bzw. eine Ergänzung zur Aufbringung einer Antireflexschicht auf die Silizium-Solarzelle dar.

Eine naßchemische Strukturätzung von Silizium vergrößert die Oberfläche von Silizium. Aus diesem Grund ist eine naßchemische Strukturätzung von Silizium geeignet für Erzeugnisse, bei denen die Oberfläche des Siliziums möglichst groß sein soll. Naßchemische Strukturätzung von Silizium ist geeignet für Solarzellen, für optische, für elektrochemische, für Bio-Detektoren bzw. -Sensoren, für Katalysatoren, für Elektroden usw.

Bekannte Verfahren zur naßchemischen pyramidalen Struktur (Textur-)Ätzung der (100) -orientierten Siliziumoberfläche arbeiten mit basischen Medien, vorwiegend mit Lösungen von Alkalihydroxiden bzw. Alkalicarbonaten, weniger - wegen ihrer Toxizität - mit Lösungen von Hydrazin bzw. Ethylen-Diamin/Brenz-katechin. Die gängigsten Rezepturen auf der Basis von Alkalihydroxiden bestehen aus Waser, Natrium- bzw. Kaliumhydroxid, Alkohol (Ethylenglykol bzw. i-Propanol) und Silizium bzw. Siliziumoxid. Bei den bekannten Verfahren zur naßchemischen Strukturätzung von Silizium geht es stets nur um die Erzeugung einer pyramidalen (tetragonalen) Textur schlechthin.

Zur Gewährleistung einer stetig guten elektrischen Qualität von in großer Stückzahl produzierten Erzeugnissen, beispielsweise Solarzellen, ist es vorteilhaft, eine möglichst gleichbleibend gute Qualität in der Ausbildung der Oberflächenstrukturen, beispielsweise der Pyramiden, einzuhalten. Dies umfaßt unter anderem eine möglichst enge Variation (Toleranz) der Oberflächenstrukturen, beispielsweise der Größe von Pyramiden, möglichst ungestört entwickelte Seitenflächen der Oberflächenstrukturen, beispielsweise der Pyramiden, sowie eine vollständige Textur der Oberfläche.

Der vorliegenden Erfindung liegt die Aufgabe zugrunde, ein Verfahren der eingangs genannten Art anzugeben, das eine reproduzierbare Herstellung bestimmter Oberflächenstrukturen bei gleichzeitig vollständiger Textur der Scheibenoberfläche ermöglicht.

Diese Aufgabe wird erfindungsgemäß durch ein Verfahren nach Patentanspruch 1 gelöst.

Eine Ausgestaltung der Erfindung ist in Patentanspruch 2 angegeben.

Ausgestaltungen und Vorteile der Erfindung ergeben sich aus der Beschreibung.

Für die Erfindung können Medien verwendet werden, deren Rezepte bereits bekannt sind. Solche Medien umfassen beipielsweise Wasser/basisches Reagenz/Alkohol und Silizium bzw. Siliziumoxid, z. B. Wasser/Kaliumhydroxid/Ethylenglykol/Silizium (vgl. US-PS 4 137 123). Erfindungsgemäß wird als weitere Komponente Sauerstoff eingeführt.

Aus zahlreichen Versuchen ergab sich, daß zur reproduzierbaren Herstellung bestimmter Pyramidenhöhen -bei gleichzeitig vollständiger und gleichmäßiger Textur- eine gewisse Umsetzung der Ätzlösung mit Sauerstoff vorteilhaft ist, erkennbar an der sich einstellenden Färbung der Lösung. Danach richtet sich auch die benötigte aufzulösende Menge an Silizium bzw. Siliziumoxid. Je nach Färbung der Ätzlösung konnten mit dem Verfahren gezielt reproduzierbar tetragonale Pyramiden der erwünschten Höhe hergestellt werden.

Die Erfindung wird im folgenden anhand der Zeichnung näher erläutert.

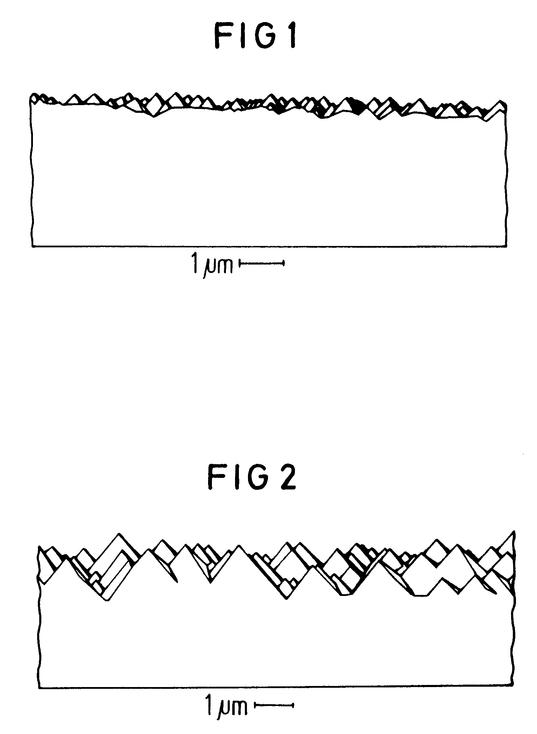

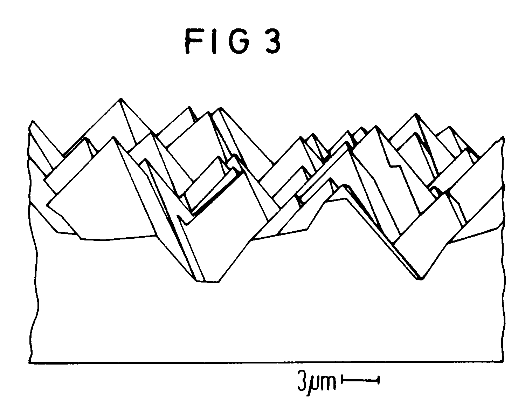

FIG 1 bis 3 zeigen Rasterelektronenmikroskop-Aufnahmen für verschiedene Bereiche von Pyramidenhöhen.

Bei verschiedenen Ausführungen wurden jeweils Ätzlösungen verwendet, die aus 5 bis 10 Litern Wasser, etwa 500 g Kaliumhydroxid und etwa 2 bis 3 Litern Ethylenglykol bestanden. Diese Lösung wurde auf eine Temperatur zwischen 80 und 100° C erhitzt. Mit Hilfe eines Belüfters (Bubbler) wurde diese Lösung bei einem Druck von 1 bar und bei einer Preßluft von 15-20 Litern pro Minute über einen Bereich von etwa einer halben Stunde bis zu 4 Stunden mit Sauerstoff versehen. Auch andere Verfahren sind zur Sauerstoffzuführung möglich, beispielsweise mit Hilfe eines Rührers. Über die Belüftungszeit hinweg ist die Ätzlösung unter den übrigen angegebenen Bedingungen mit Sauerstoff gesättigt. Nach der Zuführung von Sauerstoff wird der Ätzlösung Silizium bzw. Siliziumoxid beigefügt. Der obengenannten Ätzlösung werden beispielsweise 30 bis 50 g Silizium beigefügt.

Wird die Ätzlösung nur etwa 30 Minuten mit Sauerstoff belüftet, so erhält man nach der naßchemischen Strukturätzung von Silizium reproduzierbar gleichmäßige Pyramiden mit einer Höhe von etwa 8-10 Mikrometern. Bei einer Belüftung der Ätzlösung über 4 Stunden hinweg erhält man reproduzierbar gleichmäßige Pyramiden mit einer Höhe von 0,5-4 Mikrometern.
- FIG 1: zeigt eine gleichmäßige Pyramidenstruktur mit einer Höhe der Pyramiden von etwa 0,5 Mikrometern.
- FIG 2: zeigt eine gleichmäßige Pyramidenstruktur mit einer Pyramidenhöhe von etwa 2 Mikrometern.
- FIG 3: zeigt eine gleichmäßige Pyramidenstruktur mit einer Pyramidenhöhe von etwa 9 Mikrometern.

## Patentansprüche

1. Verfahren zur naßchemischen Texturätzung von Silizium mit den Schritten:
- Vorbereitung einer Lösung aus Wasser, Kaliumhydroxid und einem Alkohol,
- Einblasen von Luft oder Sauerstoff in die Lösung während einer Belüftungszeit,
- Hinzufügen zur Lösung von Silizium oder SiO₂ und
- Ätzen einer (100) orientierten Siliziumoberfläche mit der genannten vorbereiteten Lösung,
wobei gleichmäßige Pyramiden in der Siliziumoberfläche erhalten werden, und wobei die Höhe der Pyramiden über die Belüftungszeit eingestellt wird.

2. Verfahren nach Anspruch 1, bei dem das Einblasen von Luft oder Sauerstoff in die Lösung bis zur Sättigungsgrenze der Lösung für Sauerstoff erfolgt.

## Revendications

1. Procédé de texturation par attaque chimique en voie humide du silicium, comprenant les stades suivants :
- préparation d'une solution d'eau, d'hydroxyde de potassium et d'un alcool,
- insufflation d'air ou d'oxygène dans la solution pendant une certaine durée d'insufflation,
- addition à la solution de silicium ou de SiO₂ et
- gravure d'une surface de silicium à orientation (100) par ladite solution préparée à l'avance,
en obtenant à la surface du silicium des pyramides uniformes, la hauteur des pyramides étant réglée par la durée d'insufflation.

2. Procédé suivant la revendication 1, qui consiste à effectuer l'insufflation d'air ou d'oxygène dans la solution jusqu'à la limite de saturation de la solution pour l'oxygène.

## Claims

1. Process for wet-chemical texture-etching of silicon comprising the steps:
- preparation of a solution of water, potassium hydroxide and an alcohol,
- injection of air or oxygen into the solution during an aeration period,
- addition, to the solution, of silicon or SiO₂ and
- etching an (100) -oriented silicon surface using said prepared solution,
uniform pyramids being obtained in the silicon surface, and the height of the pyramids being defined by means of the aeration period.

2. Process according to Claim 1, in which the injection of air or oxygen into the solution is carried out until the oxygen saturation limit of the solution is reached.
